# EUROPÄISCHE PATENTSCHRIFT

(11) **EP 3 411 724 B1**
(45) Veröffentlichungstag und Bekanntmachung des Hinweises auf die Patenterteilung: **17.12.2025**
(21) Anmeldenummer: 17701819.9
(22) Anmeldetag: 18.01.2017
(51) Int. Cl.: G01R 31/26

(54) **ALTERUNGSDETEKTOR FÜR EINE ELEKTRISCHE SCHALTUNGSKOMPONENTE, VERFAHREN ZUR ÜBERWACHUNG EINER ALTERUNG EINER SCHALTUNGSKOMPONENTE, BAUELEMENT UND STEUERGERÄT**
AGEING DETECTOR FOR AN ELECTRICAL CIRCUIT COMPONENT, METHOD FOR MONITORING AGEING OF A CIRCUIT COMPONENT, COMPONENT AND CONTROL DEVICE
DÉTECTEUR DE VIEILLISSEMENT D'UN COMPOSANT DE CIRCUIT ÉLECTRIQUE, PROCÉDÉ DE SURVEILLANCE DU VIEILLISSEMENT D'UN COMPOSANT DE CIRCUIT, COMPOSANT ET DISPOSITIF DE COMMANDE

(30) Priorität: 03.02.2016 DE 102016201596
(43) Veröffentlichungstag der Anmeldung: 12.12.2018
(73) Patentinhaber: Robert Bosch GmbH, 70442 Stuttgart (DE)
(72) Erfinder: DIETZ, Franz, 72820 Willmandingen (DE); SCHNEIDER, Daniel, 72800 Eningen Unter Achalm (DE)
(86) Internationale Anmeldenummer: PCT/EP2017/050953
(87) Internationale Veröffentlichungsnummer: WO 2017/133891

(56) Entgegenhaltungen:
- EP-A1- 2 884 663
- DE-A1- 10 161 998
- US-A1- 2009 113 358
- US-A1- 2011 101 990
- US-A1- 2014 049 242
- US-B1- 7 219 045

## Beschreibung

Die vorliegende Erfindung betrifft einen Alterungsdetektor für eine elektrische Schaltungskomponente, ein Verfahren zur Überwachung einer Alterung einer Schaltungskomponente, ein Bauelement und ein Steuergerät.

### Stand der Technik

Integrierte Schaltungen enthalten heute eine Vielzahl von, auch synonyme Bauelemente genannte, aktiven und passiven Schaltungskomponenten wie beispielsweise Transistoren, Widerstände und Kapazitäten. Diese Bauelemente sind im aktiven und passiven Betrieb Alterungsmechanismen, zum Beispiel durch negative Vorspannung bedingte Temperaturinstabilität (NBTI für *negative bias temperature instability*), HCl und/oder Elektromigration, unterworfen, welche zu einer Degradation von Schaltungskomponentenparametern, zum Beispiel Änderung von Schwellspannung, Sättigungsstrom, Innenwiderstand und/oder Durchbruchspannung, und damit zu einer Fehlfunktion beziehungsweise zum Ausfall der integrierten Schaltung führen können.

Den Bauelementen können Informationen unzerstörerisch auslesbar einprogrammiert sein, aus denen eine Seriennummer und/oder ein Herstellungslos, eine Wafernummer, eine Einbauposition des Bauelements und/oder ein Verpackungslos bestimmbar sind.

In sicherheitskritischen Anwendungen, beispielsweise in Automobilanwendungen, ist Fehlfunktion beziehungsweise Ausfall unbedingt zu vermeiden. Es ist daher erstrebenswert, Informationen über Alterungsprozesse zu gewinnen.

Mithilfe von anhand standardisierter Messverfahren, zum Beispiel JEDEC Norm JP001.01; AEC-Q100, an Teststrukturen und Beispiel-Bauelementen gewonnenen Charakterisierungsdaten über Art und Stärke von Parameterdegradationen kann der Einfluss der unterschiedlichen Alterungsmechanismen auf eine integrierte Schaltung zumindest für einen oder auch mehrere typische Anwendungsfelder durch geeignete Designmaßnahmen kompensiert werden. Allerdings ergeben sich im realen Feldeinsatz aufgrund unterschiedlicher Schaltungsarten, Einsatzbedingungen und Umgebungsparametern, zum Beispiel Temperatur, sowie herstellungsbedingt streuenden Eigenschaften des Halbleitermaterials ganz unterschiedliche Verläufe der Alterungsdegradationen.

DE000010161998A1 offenbart ein Verfahren zum Überwachen des Betriebes eines Systems mit mehreren Bauelementen, wobei repräsentative Parameter für eine Alterung der Bauelemente erfasst werden, wobei ein Alterungsgrad der einzelnen Bauelemente durch Auswerten der Parameterwerte für die einzelnen Bauelemente bestimmt wird und das Überschreiten eines Schwellwertes eines Alterungsfaktors gemeldet wird, wobei der Alterungsfaktor durch Kumulation der Alterungsgrade bestimmt wird.

Weiterer Stand der Technik ist in EP 2 884 663 A1, US 2011/101990 A1, US 2009/113358 A1, US20120119825 A1, US20090113358 A1, US20100214007 A1, durch Keane et al, "On-Chip Silicon Odometers for Circuit Aging Characterization", in T. Grasser (ed.), "Biss Temperature Instability for Devices and Circuits", Springer Science+Business Media New York 2014, S. 679-717, und durch Kumar et al, "On-Chip Aging Compensation for Output Driver", IEEE Reliability Physics Symposium, 2014, Seiten CA.3.1 - CA.3.5, beschrieben.

### Offenbarung der Erfindung

Erfindungsgemäß werden ein Alterungsdetektor nach Anspruch 1, ein Verfahren nach Anspruch 6, ein Bauelement nach Anspruch 9 und ein Steuergerät für ein Fahrzeug nach Anspruch 10 zur Verfügung gestellt.

Der Alterungsdetektor ist für eine elektrische Schaltungskomponente zum Überwachen einer Alterung der Schaltungskomponente vorgesehen.

Der Alterungsdetektor gemäß der Erfindung umfasst mindestens einen Eingang zum Erfassen eines alterungsspezifischen Parameters der Schaltungskomponente eines Bauelements und ist vorgerichtet, zumindest den erfassten Parameter zum Bestimmen einer zugehörigen Reaktionsschwelle und/oder einer Reaktion oder zum Anpassen der Reaktionsschwelle und/oder der Reaktion zu verwenden. Der Alterungsdetektor ist weiterhin vorgerichtet, zumindest in Antwort auf Überschreiten der bestimmten Reaktionsschwelle durch den erfassten Parameter die Reaktion auszulösen. Der Alterungsdetektor ist dadurch gekennzeichnet, dass der Alterungsdetektor weiterhin vorgerichtet ist, den erfassten Parameter zum Anpassen der Reaktionsschwelle zu verwenden, wobei das Anpassen der Reaktionsschwelle durch Informationen erfolgt, welche durch Korrelieren von ausgelesenen Felddaten des erfassten Parameters mit Fertigungsdaten und Applikationsbedingungen zur Identifikation eines Ausfallverhaltens erhalten sind.

Durch die Möglichkeit der Bestimmung beziehungsweise Anpassung von Reaktionsschwelle und/oder Reaktion können für die Festlegung der Reaktionsschwelle und/oder der Reaktion auch Daten verwendet werden, die zum Zeitpunkt der Herstellung des Bauelements noch nicht vorgelegen haben.

Gemäß der Erfindung ist vorgesehen, dass der erfasste Parameter eine Häufigkeit und/oder eine Dauer einer bauelementkritischen Anwendung der Schaltungskomponente ist. So wird der Einfluss der bauelementkritischen Anwendung auf die Alterung erfassbar.

Der Alterungsdetektor kann mindestens einen Ausgang umfassen und vorgerichtet sein, an diesen eine Spannung anzulegen, und der Alterungsdetektor kann weiter vorgerichtet sein, einen elektrischen Widerstand oder eine Schwellspannungsdrift in Antwort auf Anlegen einer Spannung zu erfassen.

Dies ist von Vorteil, da der elektrische Widerstand zur Überwachung einer Elektromigration und/oder die Schwellspannungsdrift zur Überwachung eines durch negative Vorspannung bedingten Temperaturinstabilitätseffekts (NBTI-Effect) eines MOS-Transistors verwendet werden kann.

Das erfindungsgemäß vorgestellte Verfahren dient zur Überwachung einer Alterung einer elektrischen Schaltungskomponente eines Bauelements. Es umfasst folgende Schritte:
Bestimmen mindestens eines alterungsspezifischen Parameters,
Bestimmen einer zugehörigen parameterspezifischen Reaktionsschwelle, Auslösen einer Reaktion zumindest in Antwort auf Überschreiten der Reaktionsschwelle durch den bestimmten Parameter, und
Anpassen der Reaktionsschwelle sowie
Verwenden des bestimmten Parameters zum Anpassen der Reaktionsschwelle, wobei das Anpassen der Reaktionsschwelle durch Informationen erfolgt, welche durch Korrelieren von ausgelesenen Felddaten des erfassten Parameters mit Fertigungsdaten und Applikationsbedingungen zur Identifikation eines Ausfallverhaltens erhalten sind.

Durch die Möglichkeit der Bestimmung beziehungsweise Anpassung von Reaktionsschwelle und/oder Reaktion können für die Festlegung der Reaktionsschwelle und/oder der Reaktion auch Daten verwendet werden, die zum Zeitpunkt der Herstellung des Bauelements noch nicht vorgelegen haben.

Gemäß der Erfindung ist vorgesehen, dass der bestimmte Parameter eine Häufigkeit und/oder eine Dauer einer bauelementkritischen Anwendung der Schaltungskomponente ist.

Das Verfahren kann weiterhin Folgendes umfassen: Erfassen von Herstellungsdaten bei der Herstellung der Schaltungskomponente und Verwenden der bestimmten Herstellungsdaten zum Anpassen der Reaktionsschwelle und/oder der Reaktion.

So lassen sich Schwankungen in der Alterungsbeständigkeit unterschiedlicher Produktionschargen durch Anpassen der Reaktionsschwelle und/oder der Reaktion auch noch nachträglich kompensieren.

Das erfindungsgemäß vorgestellte Bauelement umfasst den erfindungsgemäßen Alterungsdetektor. Das erfindungsgemäß vorgestellte Steuergerät ist für ein Fahrzeug geeignet und umfasst das erfindungsgemäße Bauelement.

In einer bevorzugten Ausführungsform ist das Steuergerät vorgerichtet zur Ausführung des erfindungsgemäßen Verfahrens.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 ein Blockschaltbild eines gemäß einem Ausführungsbeispiel der Erfindung überwachten Bauelements,
Figur 2 ein Blockschaltbild eines gemäß einem Ausführungsbeispiel der Erfindung Bauelemente überwachenden Steuergeräts,
Figur 3 eine Anpassung der Reaktionsschwelle, und
Figur 4 ein Beispiel für die Verschiebung ΔP einer Alterungs-Kenngröße P.

Treten in sicherheitskritischen elektronischen Systemen unter speziellen Belastungsbedingungen Fehler auf, müssen diese Systeme - unter anderem aus Produkthaftungsgründen - ausgetauscht werden, damit sichergestellt ist, dass die bauelementkritische Kombination aus hoher Belastungsbedingung und fehlender Belastbarkeit nicht auftritt.

Die Belastbarkeit ist dabei eine individuelle Schaltungskomponente-Eigenschaft, die im realen Fertigungsablauf Schwankungen unterworfen ist.

Ein Fehler kann wiederum abhängig sein von einer zuvor erfolgten spezifischen Belastung beispielsweise auf dem Lieferweg, am Einbauort oder durch Einbau der Komponente, durch den Einsatzort, beispielsweise dessen Klima, und durch Nutzerverhalten.

Wenn jedoch nicht bekannt ist, dass ein Fehler nur infolge einer spezifischen Belastung auftritt, kann dies zur Folge haben, dass ganze Produktionschargen zurückgerufen werden müssen, obwohl lediglich die der spezifischen Belastung unterworfenen Schaltungen zurückzurufen wären.

In den nachfolgend beschriebenen Ausführungsbeispielen der Erfindung wird unter anderem ein Verfahren vorgestellt, welches eine Überwachung eines oder mehrerer Degradationsmechanismen eines Bauelements umfasst und eine Reaktionsschwelle benutzt. Dabei ist die Reaktionsschwelle spezifisch für das Bauelement und die Belastbarkeit (zum Beispiel gegenüber Temperatur oder Feuchte-Belastung des Bauelements). Die Reaktionsschwelle wird unter Verwendung der überwachten Degradationsmechanismen angepasst.

Wirken dann degradierende Einsatzbedingungen oder Kombinationen solcher Bedingungen (zum Beispiel Versorgungsspannung, Feuchte, hohe Temperatur) über lange Betriebszeiten, können beim Erreichen der gesetzten Schwellen beispielsweise Schwellen-Kombinationen geeignete Abhilfemaßnahmen eingeleitet werden. Mit diesen Maßnahmen kann dann ein Ausfall verhindert oder verzögert werden. Je nach Fehlerart kann etwa die Aktivierung eines alternativen Betriebsmodus (beispielsweise langsameres Takten eines Prozessors) oder einer Redundanz als Maßnahme dienen. Im Extremfall und bei sicherheitskritischen Komponenten kann Notwendigkeit zum präventiven Austausch der Komponente signalisiert werden.

Ein Beispiel für einen überwachten Degradationsmechanismus ist eine Häufigkeit und/oder eine Dauer bauelementkritischer Anwendungssituationen. Beispiele für bauelementkritische Anwendungssituationen umfassen Überspannungen, Fehlpolung und Übertemperatur. Zwar sind die Bauelemente ausgelegt, solche bauelementkritischen Anwendungssituationen für spezifizierte Häufigkeiten und/oder Dauern schadfrei zu überstehen. Treten jedoch solche Anwendungssituationen im Betrieb häufiger und/oder länger als ursprünglich spezifiziert auf, kann dies zu nachhaltiger Bauelementdegradation und schließlich zum Ausfall des Bauelements führen.

In beispielhaften Weiterbildungen wird auch die Art der Reaktion auf das Erreichen oder Überschreiten einer Reaktionsschwelle unter Verwendung der überwachten Degradationsmechanismen angepasst.

Durch die Möglichkeit der nachträglichen Anpassung können für die Festlegung der Reaktionsschwelle und/oder der Reaktion auch Daten verwendet werden, die zum Zeitpunkt der Herstellung des Bauelements noch nicht vorgelegen haben.

Im Kern geht es um die Möglichkeit der Rückkopplung von Informationen über Fertigungsprobleme oder Zuverlässigkeitsschwächen in schon verbaute ASIC im Feld, damit kritische Degradationen vor Eintreten eines Störfalles erkannt und behoben werden können.

Dazu werden beispielsweise die Zustandsdaten der bereits im Feld implementierten Detektoren ausgelesen (Feldbeobachtung) und mit Fertigungsdaten sowie Applikationsbedingungen korreliert, um daraus auf mögliche Zuverlässigkeitsprobleme zu schließen. Auf Basis der daraus gewonnen Informationen werden nur bei betroffenen ASIC (zum Beispiel begrenzt auf ein Fertigungslos, einen bestimmten Fertigungszeitraum oder eine spezifische Applikation) die Detektorschwellen im ASIC derart angepasst, sodass der ASIC rechtzeitig vor Erreichen eines kritischen Zustandes warnen kann.

Zum Beispiel ergibt die Auswertung von Felddaten eines ASIC-Typs, dass es in Regionen mit hoher Luftfeuchtigkeit in einer begrenzten Anzahl von Fahrzeugtypen (spezifische Einbausituation) zu einer Häufung von Ausfällen kommt. Die Korrelation mit den Fertigungsdaten schränkt die betroffenen ASIC auf einen eng definierten Fertigungszeitraum ein. Daneben ergibt die Auswertung der Detektordaten, dass bei allen betroffenen ASIC ein spezieller Detektor (zum Beispiel Feuchte) erhöhte Werte aufgewiesen hatte, seine ursprüngliche gesetzte Reaktionsschwelle aber noch nicht erreicht hatte. Durch die hier vorgestellte Erfindung kann jetzt bei den ASIC aus dem entsprechenden Fertigungszeitraum, die in den betroffenen Fahrzeugen verbaut sind, im Rahmen einer Inspektion die Reaktionsschwelle für den Feuchte-Detektor herabgesetzt werden, sodass der Detektor seine Schwelle erreicht, bevor der ASIC ausfällt. Durch die Beschränkung auf die wirklich betroffenen ASIC können einerseits die Kosten von Rückrufaktionen aber auch die Feldausfallzahlen deutlich gesenkt werden.

Weitere beispielhafte Ausführungsformen der Erfindung betreffen Alterungsdetektoren zur direkten oder indirekten Überwachung von Alterungsmechanismen beziehungsweise bauelementkritischen Anwendungssituationen.

Ein Ausführungsbeispiel eines Alterungsdetektors ist konfiguriert, über einen Ausgang eine Spannung an eine nicht direkt in der Anwendungsschaltung benutzten Leiterbahnanordnung anzulegen, deren elektrischen Widerstand zu erfassen und zur Überwachung der Elektromigration zu verwenden.

Ein weiteres Ausführungsbeispiel eines Alterungsdetektors ist konfiguriert, über einen Ausgang eine Spannung an einen oder gleichzeitig oder nacheinander an mehrere MOS-Transistoren anzulegen, eine Schwellspannungsdrift zu erfassen und zur Überwachung des NBTI Effektes zu verwenden.

Noch ein weiteres Ausführungsbeispiel eines Alterungsdetektors ist konfiguriert, eine oder mehrere Überspannungen, die nur in einer bauelementkritischen Anwendungssituation, zum Beispiel Ladungsabfall (Load Dump) bei Abklemmen einer Fahrzeug-Batterie, auftreten können, an einem Eingang zu erfassen und einen Zähler zum Zählen der Anzahl aufgetretener Einzelereignisse zu benutzen.

Wieder ein weiteres Ausführungsbeispiel eines Alterungsdetektors ist konfiguriert, eine Diode als Temperatursensor zu verwenden. Bei Überschreiten einer spezifischen Temperatur kann in Kombination mit einem auf einem Oszillator basierenden Zeitgebersignal die Dauer der Übertemperatur aufgezeichnet und aufsummiert werden.

Das Verfahren kann auch mit weiteren Alterungsdetektoren, deren Überwachung zur Bestimmung und Speicherung einer oder mehrerer oder einer Kombination von mehreren Alterungs-Kenngrößen dient, verwendet werden.

Die Auswertung der Kenngrößen kann zum Beispiel bei jeder Startprozedur der Schaltung im Feld erfolgen.

Für sicherheitskritische Anwendungen kann zusätzlich auch in-situ permanent oder in regelmäßigen Zeitintervallen im Feld eine Auswertung vorgenommen werden.

Wann und welche Auswertung vorgenommen wird, kann entweder intern in der integrierten Schaltung oder extern durch das Steuergerät gesteuert werden.

Dabei kann es sich um das Steuergerät handeln, in dem das Bauelement beziehungsweise die integrierte Schaltung verbaut ist. In Anwendungen mit mehreren Steuergeräten, beispielsweise im Automobilbereich, kann auch ein anderes Steuergerät diese Steuerung übernehmen.

In einigen Ausführungsbeispielen ist es zusätzlich beziehungsweise alternativ möglich, von außen, zum Beispiel während einer Inspektion oder Wartung, zum Beispiel über eine serielle periphere Schnittstelle (SPI für *serial peripheral interface)* oder andere Kommunikationsschnittstellen, wie beispielsweise Mobilfunk, mobilem Internet oder andere Funktechnologien in Verbindung mit der internen Fahrzeugkommunikation, eine Auswertung auszulösen.

Bei der Auswertung werden diese Kenngrößen mit Reaktionsschwellen verglichen. Die spezifischen Reaktionsschwellen können zu verschiedenen Zeitpunkten definiert beziehungsweise angepasst werden.

Beispielzeitpunkte umfassen einen Zeitpunkt eines Wafertests oder Finaltests, einen Zeitpunkt nach Einbau in ein Steuergerät durch Kommunikation mit dem Bauelement, einen Zeitpunkt nach Einbau in ein Fahrzeug oder anderen Anwendungsgegenstand, Wartungs- oder Inspektionszeitpunkte und Betriebszeitpunkte im laufenden Betrieb oder im Parkmodus.

Nach Einbau in das Steuergerät erfolgt die Auswertung dabei zum Beispiel über SPI, Mobilfunk oder andere Funktechnologien, beispielsweise in Verbindung mit der internen Fahrzeugkommunikation.

Die Bestimmung der Reaktionsschwellen erfolgt initial auf Basis von Simulations- oder Qualifikationsdaten beziehungsweise der alterungsspezifischen Bauelementparameter.

Bei sich kontinuierlich ändernden Alterungs-Kenngrößen, wie zum Beispiel Parameterdriften werden dazu nach Abschluss der Bauteilerprobung (zum Beispiel durch AEC-Q100) die überwachten Kenngrößen ausgewertet und basierend auf deren maximalem Wert ein erprobter Parameterbereich dokumentiert. Beispielsweise wird während der Erprobung die Drift (und/oder Verschiebung) ΔP= PE-P0 der Alterungskenngröße P charakterisiert. In der Serie wird die Reaktionsschwelle P_{RS} nun aus dem initial beim Bauteiltest gemessenen Wert Pᵢₙᵢₜᵢₐₗ und der während der Erprobung charakterisierten Drift bestimmt: PRS=Pᵢₙᵢₜᵢₐₗ+0.9*ΔP. Die Festlegung des Skalierungsfaktors (im Beispiel 0.9) erfolgt derart, dass eine Warnung im Betrieb zeitlich vor Überschreiten des erprobten Parameterbereiches erfolgen kann.

Bei Kenngrößen in Form von Zählern erfolgt die Festlegung der Reaktionsschwelle aufgrund von im Lastenheft spezifizierten Auftrittshäufigkeiten, die in der Erprobung abgesichert worden sind.

Bei Warnungen bezüglich Zustandsgrößen (zum Beispiel Temperatur) erfolgt die Festlegung aufgrund von im Lastenheft spezifizierten Maximalwerten. Hierzu muss das Detektorsignal (zum Beispiel Strom oder Spannung Temperaturdiode) während der Bauteilerprobung entsprechend kalibriert werden. Dies kann durch Messung des Detektorsignals bei verschiedenen Temperaturen (typisch Raumtemperatur 25°C und Hochtemperatur 140-150°C) sowie Speicherung der Temperaturcharakteristik in Form von abgeleiteten Temperaturkoeffizienten im Bauteilspeicher erfolgen. Alternativ kann die Reaktionsschwelle direkt vom Hochtemperatursignal (zum Beispiel Diodenstrom bei 150°C) abgeleitet werden. Dazu wird vorher an Testbauteilen charakterisiert, um wieviel der Diodenstrom I180 bei der gewünschten Temperaturschwelle (zum Beispiel 180°C) über dem Diodenstrom I150 bei der beim Bauteiltest benutzten Messtemperatur (zum Beispiel 150°C) liegt. Mithilfe dieses Korrekturfaktors KF = I180/I150 und dem initialen Messwert Pinitial beim Bauteiltest bei 150°C kann in der Serie die Reaktionsschwelle abgeleitet werden: PRS = Pinitial*KF.

Daneben können anwendungsspezifische Informationen wie Fahrzeug, Steuergerät, Einbauort, Wartungsintervalle und bekannte Umgebungsparameter (zum Beispiel erwartete Temperatur) zur Bestimmung der Reaktionsschwelle verwendet werden. Ziel bei der Definition der Reaktionsschwelle ist es, die Auslösung eines Alarms vor dem Eintreten eines bauelementkritischen Fehlers zu legen.

Des Weiteren können die Reaktionsschwellen anfangs auch undefiniert, also ohne Wert sein. In diesem Fall wird die Alterungskenngröße zunächst laufend ermittelt, ohne mit einer Reaktionsschwelle verglichen zu werden, und eine Reaktionsschwelle erst zu einem späteren Zeitpunkt bestimmt.

Nach Einbau können die Alterungskenngrößen regelmäßig ausgelesen werden. Beispielzeitpunkte für das Auslesen umfassen Wartungs- und Inspektionszeitpunkte sowie Betriebszeitpunkte im laufenden Betrieb oder im Parkmodus. Das Auslesen kann beispielsweise über SPI, Mobilfunk oder andere Funktechnologien, beispielsweise in Verbindung mit der internen Fahrzeugkommunikation, erfolgen.

Die so gesammelten Alterungsdaten können Bauelement- und anwendungsspezifisch ausgewertet und zur weiteren Anpassung der Reaktionsschwellen verwendet werden.

Daneben können auch Informationen über Störfälle bei der Waferprozessierung oder Verpackung oder dem Transport einzelner Herstellungslose, Wafer oder Bauelemente nachträglich zur Anpassung der Reaktionsschwellen verwendet werden.

Des Weiteren können auch alle anderen Informationen, die auf einen möglichen Fehlerfall des Bauelements hinweisen, zur Anpassung der Reaktionsschwellen verwendet werden.

Die Art der Reaktion auf das Erreichen oder Überschreiten einer Reaktionsschwelle kann unterschiedlich definiert sein.

Beispielreaktionen umfassen: keine Reaktion, Deaktivierung des Bauelements oder einzelner Funktionsgruppen, Warnung während Inspektion oder Wartung, Warnung an einen Nutzer im laufenden Betrieb durch einen Warnsignalgeber, zum Beispiel gelbe oder rote Warnlampe, und Warnung an Hersteller des Bauelements, zum Beispiel über SPI, Mobilfunk oder andere Funktechnologien, beispielsweise in Verbindung mit der internen Fahrzeugkommunikation.

Die Art der Reaktion kann zu verschiedenen Anpassungszeitpunkten definiert beziehungsweise angepasst werden. Beispielhafte Anpassungszeitpunkte umfassen den Zeitpunkt des Wafertests oder Finaltests, den Zeitpunkt nach Einbau in das Steuergerät durch Kommunikation mit dem Bauelement, den Zeitpunkt nach Einbau in das Fahrzeug oder anderen Anwendungsgegenstand, Wartungs- oder Inspektionszeitpunkte und Betriebszeitpunkte im laufenden Betrieb oder im Parkmodus.

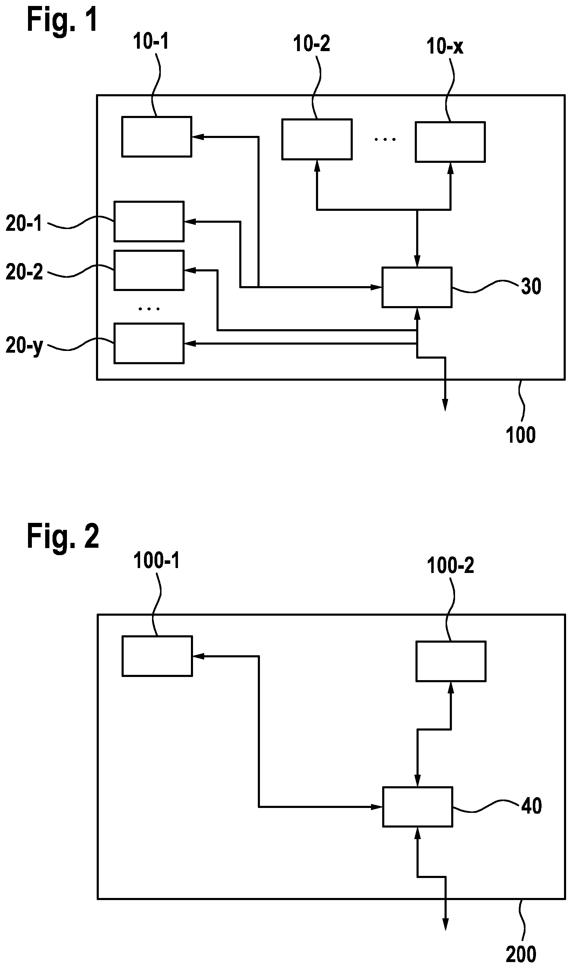

In der Figur 1 ist ein Blockschaltbild eines gemäß einem Ausführungsbeispiel der Erfindung überwachten Bauelements 100 gezeigt. Das Bauelement 100 umfasst eine Auswerteeinheit 10, Detektoren 20-1, ..., 20-x für Alterung und Detektoren 30-1, ..., 30-y für bauelementkritische Anwendungen. Die Auswerteeinheit 10 kommuniziert, bevorzugt, jedoch nicht notwendigerweise bidirektional, dabei mit den Detektoren für Alterung 20-1, ..., 20-x und mit den Detektoren 30-1, ..., 30-y für bauelementkritische Anwendungen. Die Auswerteeinheit 10 kommuniziert auch, wieder bevorzugt, jedoch nicht notwendigerweise bidirektional, mit einem zugehörigen Steuergerät, mit dem Anwendungsgegenstand, in dem das Bauelement 100 eingesetzt wird und mit Vorrichtungen außerhalb des Anwendungsgegenstands.

In der Figur 2 ist ein Blockschaltbild eines gemäß einem Ausführungsbeispiel der Erfindung Bauelemente überwachenden Steuergeräts 200 gezeigt.

Das Steuergerät umfasst beispielhaft zwei überwachte Bauelemente 100-1, 100-2 und eine Kontrolleinheit 40. Die Kontrolleinheit 40 kommuniziert, bevorzugt, jedoch nicht notwendigerweise bidirektional, mit den Auswerteeinheiten der überwachten Bauelemente 100-1, 100-2. Die Kontrolleinheit 40 kommuniziert auch, wieder bevorzugt, jedoch nicht notwendigerweise bidirektional, mit dem Anwendungsgegenstand, in dem das Bauelement 100 eingesetzt wird und mit Vorrichtungen außerhalb des Anwendungsgegenstands.

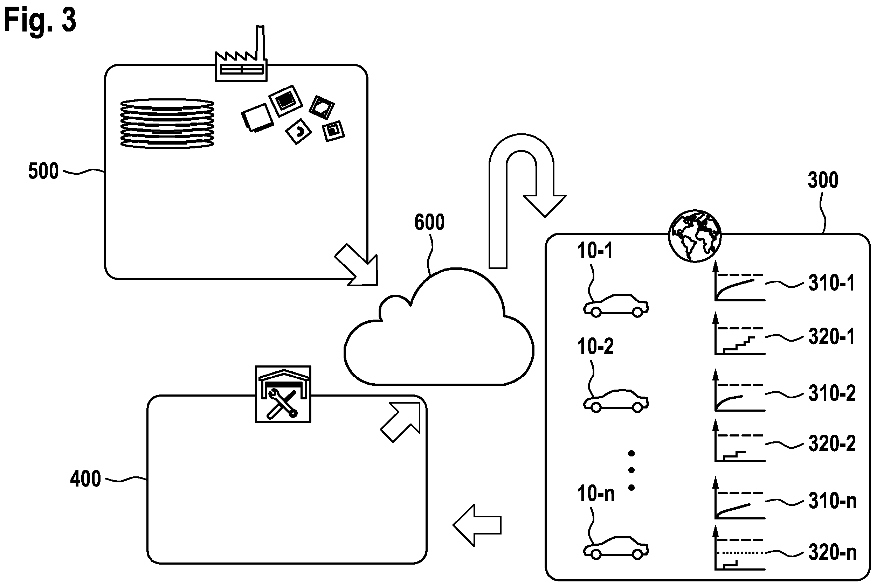

Figur 3 zeigt die Anpassung einer Reaktionsschwelle. Ein ASIC, der mittels Sensoren 30 beispielsweise verschiedene Alterungsmechanismen (mittels eines jeweiligen Sensors A aufgenommene Messkurven 310-1, 310-2, ..., 310-n) und/oder kritische Situationen (mittels eines jeweiligen Sensor B Messkurven 320-1, 320-2, ..., 320-n) überwacht, wird im Feld 300 in verschiedenen Fahrzeugen 10-1, 10-2, ..., 10-n eingesetzt. Beim regelmäßigen Service und/oder bei auftretenden Fehlerfällen werden diese Sensoren zusammen mit der ID des ASIC in einem Servicebetrieb 400 ausgelesen. Aus der Korrelation 600 dieser Felddaten mit Fertigungsdaten aus dem Fertigungsbetrieb 500 werden auffällige Fertigungslose identifiziert. Zum Beispiel, dass alle ASIC aus einem spezifischen Fertigungszeitraum ungeplant schon bei Erreichen einer reduzierten Schwelle von Sensor B ausfallen können. Basierend auf dieser Auswertung kann beim nächsten Service oder im Rahmen eines Rückrufes die Schwelle für Sensor B insofern herabgesetzt werden, dass das System rechtzeitig vor Erreichen des neu definierten Ausfallbereiches den Fahrer warnen kann.

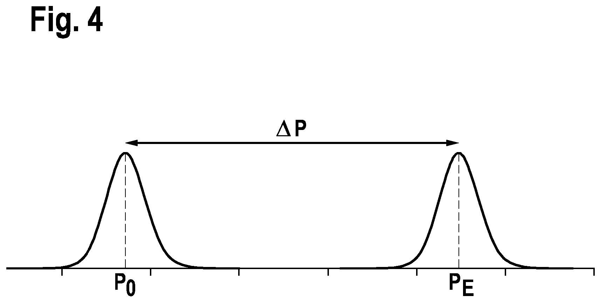

Figur 4 zeigt ein Beispiel für die Verschiebung ΔP der Alterungs-Kenngröße P während der Bauteilerprobung vom Ausgangswert P₀ zum Endwert P_{E}. Beispielhaft kann eine Ableitung der zugehörigen Reaktionsschwelle P_{RS} für ein ins Feld geliefertes Bauteil aus dessen initialem Messwert Pᵢₙᵢₜᵢₐₗ und der charakterisierten Verschiebung ΔP wie folgt erfolgen: P_{RS} = Pᵢₙᵢₜᵢₐₗ +0,9* ΔP.

## Patentansprüche

1. Alterungsdetektor (30) für eine elektrische Schaltungskomponente (100, 100-1, 100-2) eines Bauelements zum Überwachen einer Alterung der Schaltungskomponente (100, 100-1, 100-2), wobei der Alterungsdetektor (30) mindestens einen Eingang zum Erfassen eines alterungsspezifischen Parameters der Schaltungskomponente (100, 100-1, 100-2) umfasst und vorgerichtet ist zum Anpassen einer Reaktionsschwelle, wobei der Alterungsdetektor (30) weiterhin vorgerichtet ist, zumindest in Antwort auf Überschreiten der Reaktionsschwelle durch den erfassten Parameter eine Reaktion auszulösen,
**dadurch gekennzeichnet, dass**
der Alterungsdetektor (30) vorgerichtet ist, den erfassten Parameter zum Anpassen der Reaktionsschwelle zu verwenden, wobei das Anpassen der Reaktionsschwelle durch Informationen erfolgt, welche durch Korrelieren von durch den Alterungsdetektor (30) ausgelesenen Felddaten des erfassten Parameters mit Fertigungsdaten und Applikationsbedingungen zur Identifikation eines Ausfallverhaltens erhalten sind, wobei der erfasste Parameter eine Häufigkeit und/oder eine Dauer einer bauelementkritischen Anwendung der Schaltungskomponente (100, 100-1, 100-2) ist.

2. Alterungsdetektor (30) nach Anspruch 1, wobei der Alterungsdetektor (30) ferner vorgerichtet ist, den erfassten Parameter zum Anpassen der Reaktion zu verwenden.

3. Alterungsdetektor nach einem der Ansprüche 1 bis 2, wobei der Alterungsdetektor (30) mindestens einen Ausgang umfasst und vorgerichtet ist, an diesen eine Spannung anzulegen, und der Alterungsdetektor (30) weiter vorgerichtet ist, einen elektrischen Widerstand oder eine Schwellspannungsdrift in Antwort auf Anlegen einer Spannung zu erfassen.

4. Alterungsdetektor nach Anspruch 3, wobei der elektrische Widerstand zur Überwachung einer Elektromigration und/oder die Schwellspannungsdrift zur Überwachung eines durch negative Vorspannung bedingten Temperaturinstabilitätseffekts (NBTI-Effect) eines MOS-Transistors verwendet werden.

5. Alterungsdetektor nach Anspruch 4, wobei der elektrische Widerstand zur Überwachung einer Elektromigration und/oder die Schwellspannungsdrift zur Überwachung eines durch negative Vorspannung bedingten Temperaturinstabilitätseffekts (NBTI-Effect) eines Metalloxidhalbleitertransistors (MOS-Transistor) verwendet werden.

6. Verfahren zum Überwachen einer Alterung einer elektrischen Schaltungskomponente eines Bauelements mit den Schritten:
Bestimmen mindestens eines alterungsspezifischen Parameters,
Bestimmen einer zugehörigen parameterspezifischen Reaktionsschwelle, und Auslösen einer Reaktion zumindest in Antwort auf Überschreiten der Reaktionsschwelle durch den bestimmten Parameter sowie Anpassen der Reaktionsschwelle,
**dadurch gekennzeichnet, dass**
das Verfahren weiterhin das Verwenden des bestimmten Parameters zum Anpassen der Reaktionsschwelle umfasst, wobei das Anpassen der Reaktionsschwelle durch Information erfolgt, welche durch Korrelieren von ausgelesenen Felddaten des bestimmten Parameters mit Fertigungsdaten und Applikationsbedingungen zur Identifikation eines Ausfallverhaltens erhalten sind, wobei der bestimmte Parameter eine Häufigkeit und/oder eine Dauer einer bauelementkritischen Anwendung der Schaltungskomponente (100, 100-1, 100-2) ist.

7. Verfahren nach Anspruch 6, ferner umfassend das Verwenden des bestimmten Parameters zum Anpassen der Reaktion.

8. Verfahren nach einem der Ansprüche 6 bis 7, weiterhin umfassend: Erfassen von Herstellungsdaten bei der Herstellung der Schaltungskomponente und Verwenden der erfassten Herstellungsdaten zum Anpassen der Reaktionsschwelle und/oder der Reaktion.

9. Bauelement (100, 100-1, 100-2) mit einem Alterungsdetektor (30) nach einem der Ansprüche 1 bis 5.

10. Steuergerät (200) für ein Fahrzeug, wobei das Steuergerät (200) ein Bauelement (100, 100-1, 100-2) nach Anspruch 9 umfasst.

11. Steuergerät nach Anspruch 10 eingerichtet zur Ausführung eines Verfahrens nach Anspruch 6 bis 8.

## Claims

1. Ageing detector (30) for an electrical circuit component (100, 100-1, 100-2) of a component for monitoring ageing of the circuit component (100, 100-1, 100-2), wherein the ageing detector (30) comprises at least one input for detecting an ageing-specific parameter of the circuit component (100, 100-1, 100-2) and is configured for adapting a response threshold, wherein the ageing detector (30) is also configured to trigger a response at least in response to transgression of the response threshold by the detected parameter,
**characterized in that**
the ageing detector (30) is configured to use the detected parameter for adapting the response threshold, wherein the response threshold is adapted through information obtained by correlating field data relating to the detected parameter that are read out by the ageing detector (30) with production data and application conditions in order to identify a failure behaviour, wherein the detected parameter is a frequency and/or a duration of a component-critical application of the circuit component (100, 100-1, 100-2).

2. Ageing detector (30) according to Claim 1, wherein the ageing detector (30) is also configured to use the detected parameter for adapting the response.

3. Ageing detector according to either one of Claims 1 and 2, wherein the ageing detector (30) comprises at least one output and is configured to apply to it a voltage, and the ageing detector (30) is also configured to detect electrical resistance or a threshold voltage drift in response to application of a voltage.

4. Ageing detector according to Claim 3, wherein the electrical resistance is used for monitoring an electromigration and/or the threshold voltage drift is used for monitoring a negative-bias temperature instability effect (NBTI effect) of a MOS transistor.

5. Ageing detector according to Claim 4, wherein the electrical resistance is used for monitoring an electromigration and/or the threshold voltage drift is used for monitoring a negative-bias temperature instability effect (NBTI effect) of a metal-oxide semiconductor transistor (MOS transistor).

6. Method for monitoring ageing of an electrical circuit component of a component, with the steps:
determining at least one ageing-specific parameter,
determining an associated parameter-specific response threshold, and triggering a response at least in response to transgression of the response threshold by the determined parameter and
adapting the response threshold,
**characterized in that**
the method also comprises using the determined parameter for adapting the response threshold, wherein the response threshold is adapted through information obtained by correlating field data relating to the determined parameter that are read out with production data and application conditions in order to identify a failure behaviour, wherein the determined parameter is a frequency and/or a duration of a component-critical application of the circuit component (100, 100-1, 100-2).

7. Method according to Claim 6, also comprising using the determined parameter for adapting the response.

8. Method according to one of Claims 6 to 7, furthermore comprising: detecting production data during the production of the circuit component and using the detected production data for adapting the response threshold and/or the response.

9. Component (100, 100-1, 100-2) comprising an ageing detector (30) according to one of Claims 1 to 5.

10. Control device (200) for a vehicle, wherein the control device (200) comprises a component (100, 100-1, 100-2) according to Claim 9.

11. Control device according to Claim 10, configured for carrying out a method according to Claims 6 to 8.

## Revendications

1. Détecteur de vieillissement (30) pour un composant de circuit électrique (100, 100-1, 100-2) d'un élément de circuit destiné à surveiller le vieillissement du composant de circuit (100, 100-1, 100-2), le détecteur de vieillissement (30) comprenant au moins une entrée permettant de détecter un paramètre spécifique au vieillissement du composant de circuit (100, 100-1, 100-2) et étant conçu pour ajuster un seuil de réaction, le détecteur de vieillissement (30) étant en outre conçu pour déclencher une réaction au moins en réponse à un dépassement du seuil de réaction par le paramètre détecté,
**caractérisé en ce que**
le détecteur de vieillissement (30) est conçu pour utiliser le paramètre détecté afin d'ajuster le seuil de réaction, l'ajustement du seuil de réaction étant effectué par des informations obtenues en corrélant des données de terrain du paramètre détecté lues par le détecteur de vieillissement (30) avec des données de fabrication et des conditions d'application pour identifier un comportement de défaillance, le paramètre détecté étant une fréquence et/ou une durée d'application critique pour l'élément de circuit (100, 100-1, 100-2).

2. Détecteur de vieillissement (30) selon la revendication 1, le détecteur de vieillissement (30) étant également conçu pour utiliser le paramètre détecté afin d'ajuster la réaction.

3. Détecteur de vieillissement selon l'une des revendications 1 à 2, le détecteur de vieillissement (30) comprenant au moins une sortie et étant conçu pour y appliquer une tension, et le détecteur de vieillissement (30) étant en outre conçu pour détecter une résistance électrique ou une dérive de tension de seuil en réponse à l'application d'une tension.

4. Détecteur de vieillissement selon la revendication 3, dans lequel la résistance électrique est utilisée pour surveiller une électromigration et/ou la dérive de tension de seuil est utilisée pour surveiller un effet d'instabilité de température (effet NBTI) induit par une polarisation négative d'un transistor MOS.

5. Détecteur de vieillissement selon la revendication 4, dans lequel la résistance électrique est utilisée pour surveiller une électromigration et/ou la dérive de tension de seuil est utilisée pour surveiller un effet d'instabilité de température induit par une polarisation négative (effet NBTI) d'un transistor semiconducteur à oxyde métallique (transistor MOS).

6. Procédé de surveillance du vieillissement d'un composant de circuit électrique d'un élément de circuit, comprenant les étapes suivantes :
déterminer au moins un paramètre spécifique au vieillissement,
déterminer un seuil de réaction spécifique aux paramètres associés, et déclencher une réaction au moins en réponse au dépassement du seuil de réaction par le paramètre déterminé, et
ajuster le seuil de réaction,
**caractérisé en ce que**
le procédé consiste en outre à utiliser le paramètre spécifique afin d'ajuster le seuil de réaction, l'ajustement du seuil de réaction étant effectué par des informations obtenues en corrélant des données de terrain lues du paramètre déterminé avec des données de fabrication et des conditions d'application pour identifier un comportement de défaillance; le paramètre déterminé étant une fréquence et/ou une durée d'application critique pour l'élément de circuit (100, 100-1, 100-2).

7. Procédé selon la revendication 6, comprenant en outre l'utilisation du paramètre déterminé afin d'ajuster la réaction.

8. Procédé selon l'une des revendications 6 à 7, comprenant en outre l'étape suivante : détecter des données de fabrication lors de la fabrication du composant de circuit et utiliser les données de fabrication détectées afin d'ajuster le seuil de réaction et/ou la réaction.

9. Élément de circuit (100, 100-1, 100-2) comprenant un détecteur de vieillissement (30) selon l'une des revendications 1 à 5.

10. Appareil de commande (200) destiné à un véhicule, l'appareil de commande (200) comprenant un élément (100, 100-1, 100-2) selon la revendication 9.

11. Appareil de commande selon la revendication 10 destiné à mettre en œuvre un procédé selon les revendications 6 à 8.
